(19) Europäisches Patentamt / European Patent Office / Office européen des brevets

(11) **EP 3 396 805 A1**

(12) **EUROPEAN PATENT APPLICATION**
published in accordance with Art. 153(4) EPC

(43) Date of publication:
**31.10.2018 Bulletin 2018/44**

(21) Application number: **16878765.3**

(22) Date of filing: **21.12.2016**

(51) Int Cl.:
**H02J 1/00** (2006.01)  **H02H 9/02** (2006.01)
**H03K 17/16** (2006.01)  **H02H 9/00** (2006.01)
**G05F 1/573** (2006.01)  **H02J 7/00** (2006.01)
**H02H 3/24** (2006.01)  *H03K 17/082* (2006.01)

(86) International application number:
**PCT/JP2016/088112**

(87) International publication number:
**WO 2017/110878 (29.06.2017 Gazette 2017/26)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **25.12.2015 JP 2015254883**

(71) Applicants:
• **AutoNetworks Technologies, Ltd.**
  **Yokkaichi-shi, Mie 510-8503 (JP)**
• **Sumitomo Wiring Systems, Ltd.**
  **Yokkaichi-shi, Mie 510-8503 (JP)**
• **Sumitomo Electric Industries, Ltd.**
  **Osaka-shi, Osaka 541-0041 (JP)**

(72) Inventors:
• **MASE, Keisuke**
  **Yokkaichi-shi**
  **Mie 510-8503 (JP)**
• **SUGISAWA, Yuuki**
  **Yokkaichi-shi**
  **Mie 510-8503 (JP)**
• **ODA, Kota**
  **Yokkaichi-shi**
  **Mie 510-8503 (JP)**
• **SAWANO, Shunichi**
  **Yokkaichi-shi**
  **Mie 510-8503 (JP)**

(74) Representative: **Horn Kleimann Waitzhofer
Patentanwälte PartG mbB
Ganghoferstrasse 29a
80339 München (DE)**

(54) **POWER FEED CONTROL DEVICE**

(57)    In a power supply control apparatus (11), a control circuit (23) adjusts a resistance between a drain and a source of a semiconductor transistor (20) by adjusting the voltage at a gate of the semiconductor transistor (20). After the control circuit (23) has lowered the resistance between the drain and the source, a control portion (56) determines whether or not the voltage at the source detected by a voltage detecting portion (21) is larger than or equal to a standard voltage. If it is determined by the control portion (56) that the voltage at the source is larger than or equal to the standard voltage, the control circuit (23) again lowers the resistance between the drain and the source. If it is determined by the control portion (56) that the voltage at the source is smaller than the standard voltage, the control circuit (23) adjusts the resistance between the drain and the source to a resistance at the time when determination was performed or larger.

FIG. 1

## Description

Technical Field

The present invention relates to a power supply control apparatus for controlling power supply from a battery to a load.

Background Art

Vehicles are equipped with a power supply control apparatus for controlling power supply to a capacitive load by turning ON or OFF a switch that is provided on a current path from a battery to the load. In this power supply control apparatus, if the switch is turned ON from the OFF state with a small amount of power being stored in a capacitor that is included in the load, a large current temporarily flows from the battery to the load since there is a large voltage difference between the battery and the load, and the resistance between both ends of the switch is small. This current is called "inrush current". If an inrush current flows, for example, there is a concern that constituent components of the load will be burn out.

Patent Document 1 discloses a power supply control apparatus that prevents the occurrence of an inrush current. In this power supply control apparatus, one end of a series circuit of a resistor and a second switch is connected to one end of a switch, the other end of this series circuit is connected to the other end of the switch, and a current flows from a battery to a load via the switch or the series circuit. The second switch is turned ON from the OFF state before turning ON the switch from the OFF state. Thus, a current flows from the battery to the load via the resistor and the second switch.

Here, since a current flows through the load via the resistor, an inrush current does not flow even if the amount of power stored in a capacitor in the load is small. After a certain amount of power is stored in the capacitor, the second switch is turned OFF, and the switch is turned ON. Thus, power can be supplied from the battery to the load via the switch, while no power is consumed by the resistor in the series circuit.

Citation List

Patent Documents

Patent Document 1: JP 2004-135389A

Summary of Invention

Technical Problem

A power supply control apparatus that includes a semiconductor transistor, e.g. an FET (Field Effect Transistor) is conceivable as a power supply control apparatus that prevents an inrush current from flowing through a load, such as the power supply control apparatus described in Patent Document 1. In this power supply control apparatus, a semiconductor transistor is connected between a positive electrode of a battery and one end of a load, and a negative electrode of the battery and the other end of the load are grounded. In the semiconductor transistor, a current is input from the battery to an input terminal, and the input current is output from an output terminal to the load. A resistance between the input terminal and the output terminal of the semiconductor transistor is adjusted by adjusting a voltage at a control end of the semiconductor transistor, e.g. a gate of an FET. In this power supply control apparatus, the resistance between the input terminal and the output terminal of the semiconductor transistor is gradually lowered. Thus, an inrush current is prevented from flowing through the load.

Usually, a power supply control apparatus for controlling power supply to a load via a semiconductor transistor is provided with a configuration in which an overcurrent is prevented from flowing through the semiconductor transistor. For example, an output circuit is provided that outputs a higher voltage as the current flowing through the load is larger. If the voltage output by the output circuit is larger than or equal to a predetermined voltage, the resistance between the input terminal and the output terminal of the semiconductor transistor is increased. Thus, a current that is larger than or equal to a predetermined current does not flow through the semiconductor transistor, and an overcurrent is prevented from flowing through the semiconductor transistor.

However, if the output circuit is configured to generate the voltage to be output by dividing the voltage at the output terminal of the semiconductor transistor, the output circuit cannot output a voltage that exceeds the predetermined voltage when the voltage at the output terminal of the semiconductor transistor is smaller than the predetermined voltage.

Accordingly, when the resistance between the input terminal and the output terminal of the semiconductor transistor is lowered to supply power to the load, even if a current that is larger than or equal to the predetermined current flows while the voltage at the output terminal of the semiconductor transistor is smaller than the predetermined voltage, the resistance between the input terminal and the output terminal of the semiconductor transistor is not increased. The power supply control apparatus that includes such an output circuit has a problem in that a flow of an overcurrent cannot be reliably prevented.

The present invention has been made in view of the foregoing situation, and aims to provide a power supply control apparatus capable of reliably preventing a flow of an inrush current and an overcurrent.

Solution to Problem

A power supply control apparatus according to the present invention is A power supply control apparatus that includes a semiconductor transistor for outputting a current that is input to its input terminal, from its output terminal to a capacitive load, and an adjusting portion for adjusting a resistance between the input terminal and the output terminal of the semiconductor transistor, and controls power supply to the load by adjusting the resistance with the adjusting portion, the power supply control apparatus including: a detecting portion for detecting a voltage at the output terminal; and a determining portion for determining whether or not the voltage at the output terminal detected by the detecting portion is larger than or equal to a predetermined voltage, after the adjusting portion has lowered the resistance, wherein the adjusting portion again lowers the resistance if it is determined by the determining portion that the voltage at the output terminal is larger than or equal to the predetermined voltage, and if it is determined by the determining portion that the voltage at the output terminal is smaller than the predetermined voltage, adjusts the resistance to at least the resistance at the time when the determining portion performed the determination.

In the present invention, for example, a current is input to the input terminal of the semiconductor transistor from the battery, and the input current is output from the output terminal of the semiconductor transistor to the capacitive load. By gradually increasing the resistance between the input terminal and the output terminal of the semiconductor transistor, an inrush current can be reliably prevented from flowing through the semiconductor transistor.

The resistance between the input terminal and the output terminal of the semiconductor transistor is lowered to supply power to the load. Thus, power is stored in the capacitor in the load. After the resistance is lowered, it is determined whether or not the detected voltage at the output terminal is larger than or equal to the predetermined voltage. If both ends of the load are shorted and there is a possibility that an overcurrent will flow through the semiconductor transistor, the voltage at the output terminal is substantially 0 V, and accordingly is smaller than the predetermined voltage. If both ends of the load are not shorted, the voltage at the output terminal is larger than or equal to the predetermined voltage.

If it is determined that the voltage at the output terminal is larger than or equal to the predetermined voltage, the resistance between the input terminal and the output terminal of the semiconductor transistor is lowered again, and power is supplied to the load. If it is determined that the voltage at the output terminal is smaller than the predetermined voltage, the resistance between the input terminal and the output terminal of the semiconductor transistor is adjusted to a resistance at the time when the determination was performed or larger, and an overcurrent is reliably prevented from flowing through the semiconductor transistor.

In the power supply control apparatus according to the present invention, the adjusting portion lowers the resistance and thereafter increases the resistance before the determining portion performs the determination, and the determining portion performs the determination after the adjusting portion has increased the resistance.

In the present invention, the resistance between the input terminal and the output terminal of the semiconductor transistor is lowered, and power is supplied to the capacitor in the load. Then, the resistance is increased, and power supply is stopped. Thereafter, it is determined whether or not the voltage at the output terminal of the semiconductor transistor is larger than or equal to the predetermined voltage. Since power supply temporarily stops, power is not needlessly consumed when both ends of the load are shorted.

The power supply control apparatus according to the present invention further includes an output circuit that outputs a higher voltage the larger a current flowing through the load is, wherein the adjusting portion increases the resistance if the voltage output by the output circuit is larger than or equal to a threshold, and the largest value of the voltage output by the output circuit is smaller than or equal to the voltage at the output terminal, and increases with an increase in the voltage at the output terminal.

In the present invention, if the voltage output by the output circuit is larger than or equal to the threshold, the resistance between the input terminal and the output terminal of the semiconductor transistor is increased. If the voltage at the output terminal of the semiconductor transistor is high, the largest value of the voltage output by the output circuit is large. For this reason, a configuration in which the resistance is increased based on the voltage output by the output circuit appropriately works. Accordingly, a flow of an overcurrent is prevented. If the voltage at the output terminal of the semiconductor transistor is low, the smallest value of the voltage output by the output circuit is small. For this reason, the configuration in which the resistance is increased based on the voltage output by the output circuit does not appropriately work. A flow of an overcurrent is prevented by resistance adjustment that is performed based on the detected voltage at the output terminal.

Advantageous Effects of Invention

According to the present invention, a flow of an inrush current and an overcurrent can be reliably prevented.

Brief Description of Drawings

FIG. 1 is a block diagram showing a configuration of essential parts of a power supply system according to Embodiment 1.
FIG. 2 is a circuit diagram of an output circuit.
FIG. 3 is a circuit diagram of a control circuit.

FIG. 4 is a flowchart showing a procedure of start processing executed by a control portion.
FIG. 5 is a timing chart showing an example of operations in a power supply control apparatus.
FIG. 6 is a timing chart showing another example of operations in the power supply control apparatus.
FIG. 7 is a flowchart showing a procedure of start processing executed by a control portion according to Embodiment 2.
FIG. 8 is a timing chart showing an example of operations of the power supply control apparatus.
FIG. 9 is a timing chart showing another example of operations of the power supply control apparatus.

Description of Embodiments

Hereinafter, the present invention will be described in detail based on the drawings illustrating the embodiments.

Embodiment 1

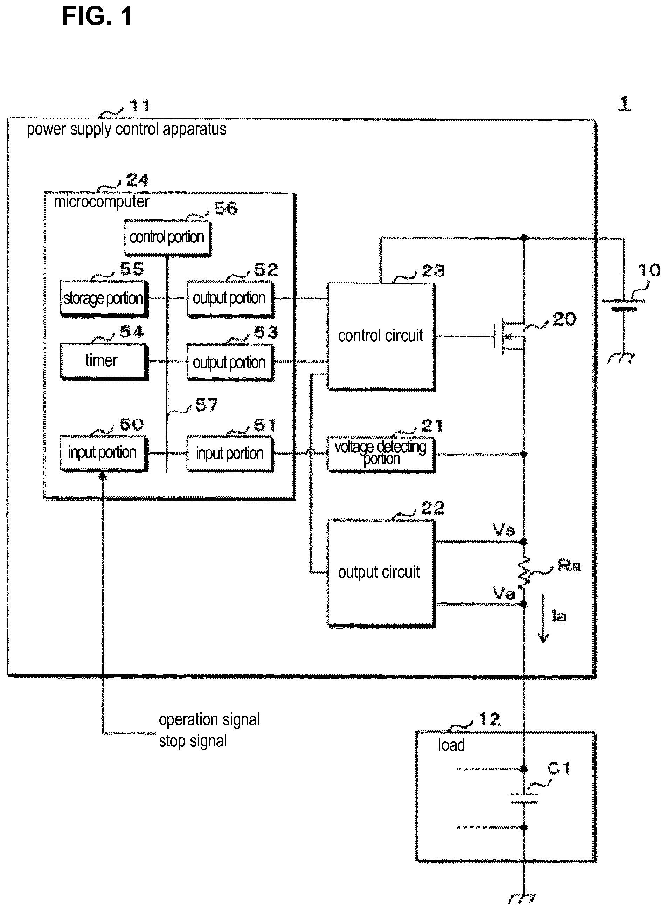

FIG. 1 is a block diagram showing a configuration of essential parts of a power supply system 1 according to Embodiment 1. The power supply system 1 is favorably mounted in a vehicle, and includes a battery 10, a power supply control apparatus 11, and a capacitive load 12. The load 12 has a capacitor C1. A positive electrode of the battery 10 and one end of a capacitor C1, which is included in the load 12, are connected to the power supply control apparatus 11. A negative electrode of the battery 10 and the other end of the capacitor C1 included in the load 12 are grounded.

An operation signal for giving an instruction to operate the load 12 and a stop signal for giving an instruction to stop operation of the load 12 are input to the power supply control apparatus 11. The power supply control apparatus 11 controls power supply from the battery 10 to the load 12 based on the input signal.

The load 12 is an electric device that is mounted in the vehicle. The load 12 operates while power is supplied from the battery 10 to the load 12. The load 12 stops its operation while power supply from the battery 10 to the load 12 is stopped.

The power supply control apparatus 11 has a semiconductor transistor 20, a voltage detecting portion 21, an output circuit 22, a control circuit 23, a microcomputer 24, and a resistor Ra. Of the semiconductor transistor 20, a drain is connected to the positive electrode of the battery 10, and a source is connected to one end of the resistor Ra. The other end of the resistor Ra is connected to one end of the capacitor C1 in the load 12. A gate of the semiconductor transistor 20 is connected to the control circuit 23. The control circuit 23 is also connected to the positive electrode of the battery 10, the output circuit 22, and the microcomputer 24. A voltage detecting portion 21 is connected to the source of the semiconductor transistor 20 and the microcomputer 24.

The output circuit 22 is connected to one end and the other end of the resistor Ra, in addition to control circuit 23.

A current is input from the positive electrode of the battery 10 to the drain of the semiconductor transistor 20, and the current input to the drain is output from the source of the semiconductor transistor 20 to the load 12 via the resistor Ra. The drain and the source function as an input terminal and an output terminal, respectively.

In the semiconductor transistor 20, the resistance between the drain and the source depends on the voltage at the gate (hereinafter referred to as gate voltage), which is based on a ground potential serving as a reference. In the semiconductor transistor 20, the resistance between the drain and the source decreases if the gate voltage increases. A voltage is applied to the gate of the semiconductor transistor 20 by the control circuit 23. The control circuit 23 adjusts the resistance between the drain and the source of the semiconductor transistor 20 by adjusting the gate voltage of the semiconductor transistor 20. The control circuit 23 functions as an adjusting portion.

The control circuit 23 lowers the resistance between the drain and the source of the semiconductor transistor 20 by increasing the gate voltage of the semiconductor transistor 20. Thus, power is supplied from the battery 10 to the load 12 via the semiconductor transistor 20 and the resistor Ra.

Also, the control circuit 23 increases the resistance between the drain and the source of the semiconductor transistor 20 by lowering the gate voltage of the semiconductor transistor 20. Thus, power supply from the battery 10 to the load 12 is stopped.

As described above, the control circuit 23 controls power supply to the load 12 by adjusting the resistance between the drain and the source of the semiconductor transistor 20.

The voltage detecting portion 21 detects the voltage at the source (hereinafter referred to as source voltage) of the semiconductor transistor 20, which is based on the ground potential serving as a reference. The voltage detecting portion 21 outputs voltage information, which indicates the detected source voltage, to the microcomputer 24.

The output circuit 22 outputs a voltage to the control circuit 23. The voltage output to the control circuit 23 by the output circuit 22 increases with an increase in a load current $Ia$, which is a current flowing through the load 12 via the resistor Ra, and accordingly is higher the larger the load current $Ia$ is.

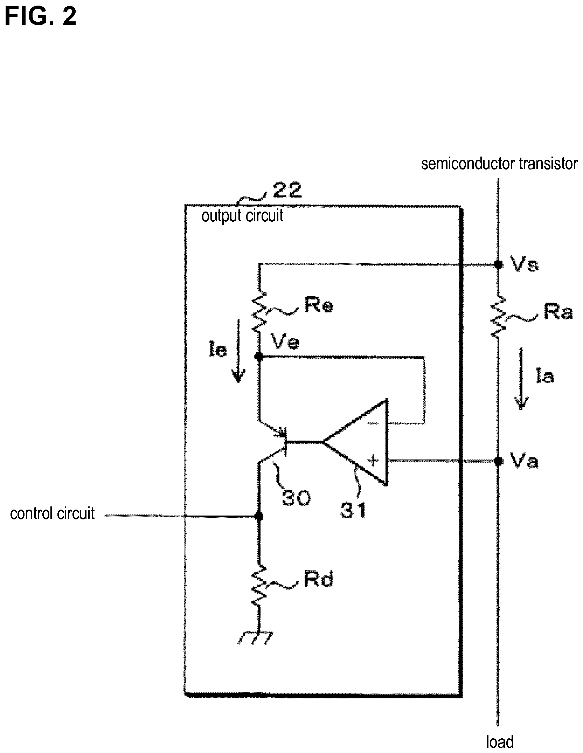

FIG. 2 is a circuit diagram of the output circuit 22. The output circuit 22 has a PNP bipolar transistor 30, a differential amplifier 31, and resistors Rd and Re. One end of the resistor Re is connected to the source of the semiconductor transistor 20. The other end of the resistor Re is connected to an emitter of the bipolar transistor 30 and a minus terminal of the differential amplifier 31. A plus terminal of the differential amplifier 31 is connected to one end of the resistor Ra on the load 12 side. An output terminal of the differential amplifier 31 is connected to a base of the bipolar transistor 30. A collector of the bipolar transistor 30 is connected to the control circuit 23 and one end of the resistor Rd. The other end of the resistor Rd is grounded.

Most of the current output from the source of the semiconductor transistor 20 flows through the load 12 via the resistor Ra. The remainder of the current output from the source of the semiconductor transistor 20 flows to the resistor Re, the bipolar transistor 30, and the resistor Rd in this order. In the bipolar transistor 30, the current is input to the emitter, and the current input to the emitter is output from the collector to the resistor Rd.

In the bipolar transistor 30, the resistance between the emitter and the collector depends on the voltage at the base, which is based on the ground potential serving as a reference. If the voltage at the base of the bipolar transistor 30 increases, the resistance between the emitter and the collector of the bipolar transistor 30 increases. A voltage is applied to the base of the bipolar transistor 30 by the differential amplifier 31.

The source voltage of the semiconductor transistor 20 will be denoted as Vs. The resistance between the emitter and the collector of the bipolar transistor 30 will be denoted as rb. The resistance values of the resistors Rd and Re will be denoted as rd and re, respectively. An emitter current Ie that is input to the emitter of the bipolar transistor 30 is calculated by $Vs/(rb+rd+re)$. If the resistance value rb decreases, the emitter current Ie increases. If the resistance value rb increases, the emitter current Ie decreases.

In the differential amplifier 31, the voltage applied from the output terminal to the base of the bipolar transistor 30 depends on an emitter voltage Ve that is applied to the minus terminal, and on a load voltage Va that is applied to the plus terminal.

If the emitter voltage Ve is higher than the load voltage Va, the differential amplifier 31 lowers the voltage that is applied to the base of the bipolar transistor 30. The voltage decreases more the greater the difference between the emitter voltage Ve and the load voltage Va is. The resistance value rb between the emitter and the collector of the bipolar transistor 30 decreases due to the decrease in the voltage at the base of the bipolar transistor 30. As a result, the emitter current Ie increases, the magnitude of the voltage drop that occurs at the resistor Re increases, and the emitter voltage Ve decreases. The emitter voltage Ve comes to approximate the load voltage Va.

If the emitter voltage Ve is lower than the load voltage Va, the differential amplifier 31 increases the voltage applied to the base of the bipolar transistor 30. The voltage increases more as the difference between the emitter voltage Ve and the load voltage Va is greater. The resistance value rb between the emitter and the collector of the bipolar transistor 30 increases with the increase in the voltage at the base of the bipolar transistor 30. As a result, the emitter current Ie decreases, the magnitude of the voltage drop that occurs at the resistor Re decreases, and the emitter voltage Ve increases. The emitter voltage Ve comes to approximate the load voltage Va.

As described above, the differential amplifier 31 adjusts the resistance value rb between the emitter and the collector of the semiconductor transistor 20 so that the emitter voltage Ve coincides with the load voltage Va. Since the emitter voltage Ve coincides with the load voltage Va, the following equation (1) holds.

$$Vs\text{-}re\times Ie = Vs\text{-}ra\times Ia \ \dots \ (1)$$

Here, ra denotes the resistance value of the resistor Ra.

The following equation (2) holds as a result of expanding the equation (1).

$$Ie = Ia\times ra/re \ \dots \ (2)$$

For example, if the resistance value re is 1000 times the resistance value ra, the emitter current Ie is one-thousandth of the load current Ia. Thus, the emitter current Ie is a fraction of a predetermined number of the load current Ia, and the predetermined number is determined by the resistance values ra and re.

The bipolar transistor 30 and the resistors Rd and Re divide the source voltage Vs, and the divided voltage is output to the control circuit 23. The voltage output from the output circuit 22 to the control circuit 23 is $rd\times Ie$. Since the emitter current Ie is expressed as $Ia\times ra/re$ as mentioned above, the voltage output from the output circuit 22 to the control circuit 23 is $Ia\times ra\times rd/re$. Since the resistance values ra, rd, and re are constants, the voltage output from the output circuit 22 to the control circuit 23 is proportional to the load current Ia.

However, the range of the load current Ia in which the voltage output from the output circuit 22 to the control circuit 23 is proportional to the load current Ia is limited.

The emitter current Ie is largest when the resistance value rb between the emitter and the collector of the bipolar transistor 30 becomes substantially 0 Ω. The largest value of the emitter current Ie is $Vs/(rd+re)$. The load current Ia that corresponds to the emitter current Ie, which is expressed as $Vs/(rd+re)$, is $Vs\times re/(ra\times(rd+re))$.

Accordingly, if the load current Ia exceeds $Vs\times re/(ra\times(rd+re))$, the equation (2) does not hold. In this case, the resistance value rb is substantially 0 Ω regardless of the load current Ia, and therefore, the voltage output from the output circuit 22 to the control circuit 23 is constant and is expressed as $Vs\times rd/(rd+re)$. Accordingly, if the source voltage Vs is low, there is a possibility that the output circuit 22 is not outputting an appropriate voltage to the control circuit 23.

The voltage is input from the output circuit 22, and a low-level voltage or a high-level voltage is input from the microcomputer 24, to the control circuit 23 shown in FIG. 1. The control circuit 23 applies a voltage to the gate of the semiconductor transistor 20. The control circuit 23 adjusts the gate voltage of the semiconductor transistor 20 based on the voltages input from the output circuit 22 and the microcomputer 24.

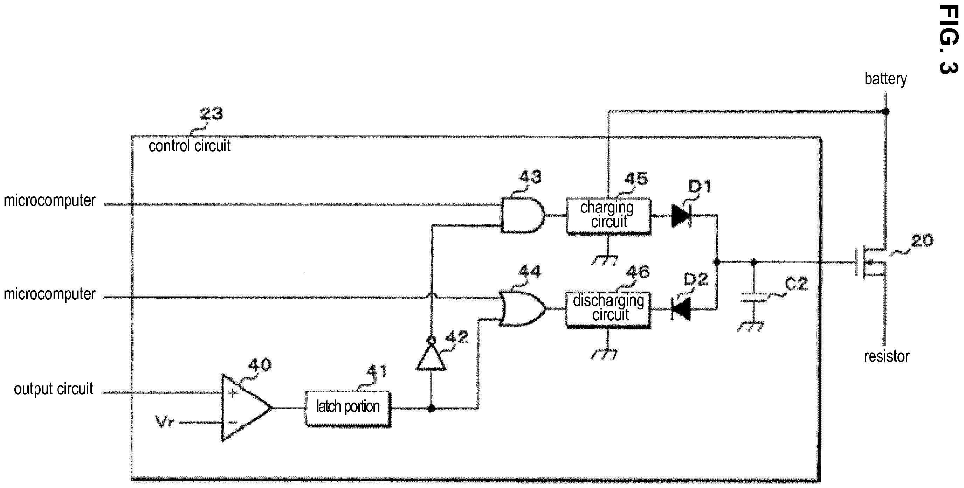

FIG. 3 is a circuit diagram of the control circuit 23. The control circuit 23 has a comparator 40, a latch portion 41, an inverter 42, an AND circuit 43, an OR circuit 44, a charging circuit 45, a discharging circuit 46, a capacitor C2, and diodes D1 and D2. The AND circuit 43 and the OR circuit 44 each have two input terminals and one output terminal.

The output circuit 22, or more specifically, the collector of the bipolar transistor 30 is connected to a plus terminal of the comparator 40. A reference voltage Vr is applied to a minus terminal of the comparator 40. The reference voltage Vr is constant, and is generated based on the output voltage of the battery 10 by using a regulator, for example. An output terminal of the comparator 40 is connected to an input terminal of the latch portion 41. An output terminal of the latch portion 41 is connected to an input terminal of the inverter 42 and a first input terminal of the OR circuit 44. An output terminal of the inverter 42 is connected to a first input terminal of the AND circuit 43. Second input terminals of the AND circuit 43 and the OR circuit 44 are separately connected to the microcomputer 24.

The output terminal of the AND circuit 43 is connected to the charging circuit 45. The charging circuit 45 is also connected to the positive electrode of the battery 10 and an anode of the diode D1. The charging circuit 45 is grounded. The output terminal of the OR circuit 44 is connected to the discharging circuit 46. The discharging circuit 46 is also connected to a cathode of the diode D2. The discharging circuit 46 is grounded.

A cathode of the diode D1 and an anode of the diode D2 are connected to the gate of the semiconductor transistor 20 and one end of the capacitor C2. The other end of the capacitor C2 is grounded.

If the voltage output from the output circuit 22 to the control circuit 23 is smaller than the reference voltage Vr, the comparator 40 outputs a low-level voltage to the latch portion 41. If the voltage output from the output circuit 22 to the control circuit 23 is greater than or equal to the reference voltage Vr, the comparator 40 outputs a high-level voltage to the latch portion 41.

The latch portion 41 outputs a low-level voltage to the input terminal of the inverter 42 and the first input terminal of the OR circuit 44 while the low-level voltage is input from the comparator 40. If the voltage input from the comparator 40 switches from the low-level voltage to the high-level voltage, the latch portion 41 outputs a high-level voltage to the input terminal of the inverter 42 and the first input terminal of the OR circuit 44. After the voltage input from the comparator 40 has switched from the low-level voltage to the high-level voltage, the latch portion 41 continues to output the high-level voltage regardless of the voltage input from the comparator 40.

If the low-level voltage is input from the latch portion 41, the inverter 42 outputs a high-level voltage to the first input terminal of the AND circuit 43. If the high-level voltage is input from the latch portion 41, the inverter 42 outputs a low-level voltage to the second input terminal of the AND circuit 43. Accordingly, while the voltage output from the output circuit 22 to the control circuit 23 is smaller than the reference voltage Vr, the high-level voltage and the low-level voltage are input to the first input terminals of the AND circuit 43 and the OR circuit 44, respectively. After the voltage output from the output circuit 22 to the control circuit 23 has become larger than or equal to the reference voltage Vr, the low-level voltage and the high-level voltage continue to be input to the first input terminals of the AND circuit 43 and the OR circuit 44, respectively.

A high-level voltage or a low-level voltage is input from the microcomputer 24 to the second input terminal of the AND circuit 43. If the high-level voltage is input to the first terminal from the inverter 42, the AND circuit 43 outputs the voltage input from the microcomputer 24 to the second input terminal, as-is, to the charging circuit 45. If the low-level voltage is input to the first terminal from the inverter 42, the AND circuit 43 outputs a low-level voltage to the charging circuit 45 regardless of the voltage input from the microcomputer 24 to the second input terminal.

Accordingly, while the voltage output from the output circuit 22 to the control circuit 23 is smaller than the reference voltage Vr, the voltage input from the microcomputer 24 to the second input terminal of the AND circuit 43 is output, as-is, to the charging circuit 45. After the voltage output from the output circuit 22 to the control circuit 23 has become larger than or equal to the reference voltage Vr, the low-level voltage is output to the charging circuit 45 regardless of the voltage input from the microcomputer 24 to the second input terminal of the AND circuit 43.

If the high-level voltage is input from the AND circuit 43, the charging circuit 45 generates a constant voltage using the battery 10, and applies the generated voltage between both ends of the capacitor C2 via the diode D1. Thus, the capacitor C2 is charged. The voltage across both ends of the capacitor C2 is applied to the gate of the semiconductor transistor 20. As the capacitor C2 is charged, the voltage across both ends of the capacitor C2 gradually increases, and the gate voltage of the semiconductor transistor 20 gradually increases. As a result, the resistance between the drain and the source of the semiconductor transistor 20 gradually decreases.

If the low-level voltage is input from the AND circuit 43, the charging circuit 45 stops its operation. At this time, the capacitor C2 is not charged.

The microcomputer 24 causes the charging circuit 45 to charge the capacitor C2 by outputting the high-level voltage to the second input terminal of the AND circuit 43, and causes the charging circuit 45 to stop charging of the capacitor C2 by outputting the low-level voltage to the second input terminal of the AND circuit 43.

A high-level voltage or a low-level voltage is input from the microcomputer 24 to the second input terminal of the OR circuit 44. If the low-level voltage is input from the latch portion 41 to the first input terminal, the OR circuit 44 outputs the voltage input from the microcomputer 24 to the second input terminal, as-is, to the discharging circuit 46. If the high-level voltage is input from the latch portion 41 to the first input terminal, the OR circuit 44 outputs a high-level voltage to the discharging circuit 46 regardless of the voltage input from the microcomputer 24 to the second input terminal.

Accordingly, while the voltage output from the output circuit 22 to the control circuit 23 is smaller than the reference voltage Vr, the voltage input from the microcomputer 24 to the second input terminal of the OR circuit 44 is output, as-is, to the discharging circuit 46. After the voltage output from the output circuit 22 to the control circuit 23 has become larger than or equal to the reference voltage Vr, the high-level voltage is output to the discharging circuit 46 regardless of the voltage input from the microcomputer 24 to the second input terminal of the OR circuit 44.

If the high-level voltage is input from the OR circuit 44, the discharging circuit 46 causes the capacitor C2 to be discharged. At this time, the cathode of the diode D2 is grounded via a resistor (not shown) in the discharging circuit 46, and a current flows from the capacitor C2 to the diode D2, the resistor in the discharging circuit 46, to the ground potential in this order. As a result of the capacitor C2 being discharged, the voltage across both ends of the capacitor C2 decreases, and the gate voltage of the semiconductor transistor 20 decreases. Thus, the resistance between the drain and the source of the semiconductor transistor 20 increases.

If the low-level voltage is input from the OR circuit 44, the discharging circuit 46 stops its operation. At this time, the cathode of the diode D2 is open, and the capacitor C2 is not charged.

The microcomputer 24 causes the discharging circuit 46 to discharge the capacitor C2 by outputting the high-level voltage to the second input terminal of the OR circuit 44, and causes the discharging circuit 46 to stop discharging of the capacitor C2 by outputting the low-level voltage to the second input terminal of the OR circuit 44.

In the control circuit 23 that is configured as described above, the charging circuit 45 and the discharging circuit 46 perform charging and discharging, respectively, in accordance with the voltage input from the microcomputer 24, while the voltage output from the output circuit 22 to the control circuit 23 is smaller than the reference voltage Vr. Furthermore, if the voltage output from the output circuit 22 to the control circuit 23 is larger than or equal to the reference voltage Vr, the charging circuit 45 stops its operation, and the discharging circuit 46 operates. Thus, the gate voltage of the semiconductor transistor 20 decreases, and the resistance between the drain and the source of the semiconductor transistor 20 increases. As a result, power supply from the battery 10 to the load 12 is interrupted. As a result, the voltage output from the output circuit 22 to the control circuit 23 does not exceed the reference voltage Vr. The reference voltage Vr corresponds to a threshold.

As mentioned above, the voltage output from the output circuit 22 to the control circuit 23 is expressed as $Ia \times ra \times rd/re$, where Ia denotes the load current, and ra, rd, and re denote the resistance values of the resistors Ra, Rd, and Re, respectively. For this reason, the voltage output from the output circuit 22 to the control circuit 23 being larger than or equal to the reference voltage Vr means that the load current Ia is larger than or equal to the current threshold Ith ($=Vr \times re/(ra \times rd)$). Accordingly, in the power supply control apparatus 11, if the load current Ia is larger than or equal to the current threshold Ith, power supply from the battery 10 to the load 12 is interrupted regardless of the voltage input from the microcomputer 24 to the control circuit 23. As a result, the load current Ia does not exceed the current threshold Ith, and an overcurrent does not flow through the semiconductor transistor 20.

As mentioned above, the voltage output from the output circuit 22 to the control circuit 23 is $rd \times Ie$, and the largest value of the emitter current Ie is $Vs/(rd+re)$. Accordingly, the largest value of the voltage output from the output circuit 22 to the control circuit 23 is $Vs \times rd/(rd+re)$. Thus, power supply is appropriately interrupted only if this largest value $Vs \times rd/(rd+re)$ is larger than or equal to the reference voltage Vr.

If the largest value $Vs \times rd/(rd+re)$ of the voltage output from the output circuit 22 to the control circuit 23 is smaller than the reference voltage Vr, the comparator 40 continues to output the low-level voltage to the latch portion 41 regardless of the magnitude of the load current Ia.

The largest value $Vs \times rd/(rd+re)$ of the voltage output from the output circuit 22 to the control circuit 23 increases with an increase in the source voltage Vs. Furthermore, since $rd/(rd+re)<1$ holds, $Vs \times rd/(rd+re)<Vs$ holds. For this reason, the largest value $Vs \times rd/(rd+re)$ of the voltage output from the output circuit 22 to the control circuit 23 is smaller than the source voltage Vs.

If the voltage across both ends of the capacitor C2 is 0 V, the gate voltage of the semiconductor transistor 20 is 0 V, and the drain and the source of the semiconductor transistor 20 is in an open state. At this time, no current flows through the resistor Ra, and accordingly, the source voltage Vs substantially coincides with the voltage across both ends of the capacitor C1 in the load 12, and is low. If the charging circuit 45 charges the capacitor C2 with the operation of the discharging circuit 46 stopped, the resistance between the drain and the source of the semiconductor transistor 20 gradually decreases, as mentioned above. As the resistance between the drain and the source between the semiconductor transistor 20 gradually decreases, the source voltage Vs gradually increases.

Here, while the largest value $Vs \times rd/(rd+re)$ of the voltage output to the control circuit 23 by the output circuit 22 is smaller than the reference voltage Vr, i.e. while the source voltage Vs is smaller than $Vr \times (rd+re)/rd$, power supply from the battery 10 to the load 12 is not interrupted even if the load current Ia is larger than or equal to the current threshold Ith ($=Vr \times re/(ra \times rd)$).

Thus, in the power supply control apparatus 11, the microcomputer 24 controls the operation of the charging circuit 45 and the discharging circuit 46 in the control circuit 23 based on the voltage information input from the voltage detecting portion 21, thereby preventing the load current Ia becoming an overcurrent while the source voltage Vs is smaller than $Vr \times (rd+re)/rd$.

The microcomputer 24 shown in FIG. 1 has input portions 50 and 51, output portions 52 and 53, a timer 54, a storage portion 55, and a control portion 56. These are connected to a bus 57. The input portion 51 is also connected to the voltage detecting portion 21. The output portion 52 is also connected to the second input terminal of the AND circuit 43 in the control circuit 23. The output portion 53 is also connected to the second input terminal of the OR circuit 44 in the control circuit 23.

An operation signal or stop signal is input to the input portion 50. If the operation signal or stop signal is input to the input portion 50, the input portion 50 notifies the control portion 56 of this signal input.

The voltage information is input to the input portion 51 from the voltage detecting portion 21. The voltage information is acquired by the control portion 56 from the input portion 51. The source voltage indicated by the voltage information acquired by the control portion 56 from the input portion 51 substantially coincides with the source voltage detected by the voltage detecting portion 21 when the control portion 56 acquires the voltage information.

The output portion 52 outputs the high-level voltage or the low-level voltage to the second terminal of the AND circuit 43 in the control circuit 23. The output portion 52 switches the voltage output to the second terminal of the AND circuit 43 in the control circuit 23 to the high-level voltage or the low-level voltage in accordance with an instruction from the control portion 56.

The output portion 53 outputs the high-level voltage or the low-level voltage to the second terminal of the OR circuit 44 in the control circuit 23. The output portion 53 switches the voltage output to the second terminal of the OR circuit 44 in the control circuit 23 to the high-level voltage or the low-level voltage in accordance with an instruction from the control portion 56.

The timer 54 starts to measure time and ends time measurement in accordance with an instruction from the control portion 56. The measured time that is measured by the timer 54 is read out by the control portion 56 from the timer 54. The measured time that is measured by the timer 54 is reset to zero by the control portion 56.

The storage unit 55 is a nonvolatile memory. A control program is stored in the storage portion 55. The control portion 56 includes a CPU (Central Processing Unit; not shown), and executes power supply start processing to start to supply power from the battery 10 to the load 12 and power supply end processing to end power supply from the battery 10 to the load 12, by executing the control program stored in the storage portion 55.

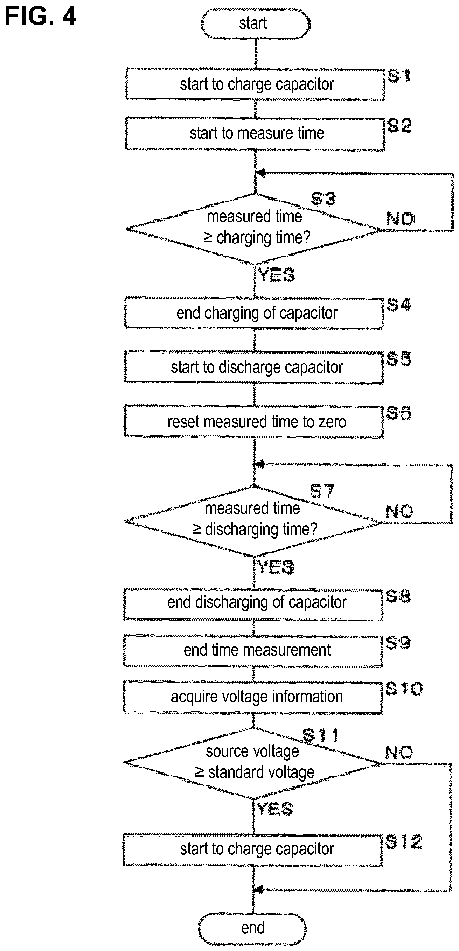

FIG. 4 is a flowchart showing a procedure of the power supply start processing executed by the control portion 56. The control portion 56 executes the power supply start processing if the operation signal is input to the input portion 50. The power supply start processing starts in a state where the output portions 52 and 53 output the low-level voltage to the second terminals of the AND circuit 43 and the OR circuit 44, respectively, in the control circuit 23, i.e. in a state where the charging circuit 45 and the discharging circuit 46 stop operation.

Initially, the control portion 56 instructs the output portion 52 to switch the voltage output to the control circuit 23 by the output portion 52 to the high-level voltage, and thus causes the charging circuit 45 to start to charge the capacitor C2 in the control circuit 23 (step S1). When step S1 is executed, the load current Ia is 0 A, and accordingly, the voltage output from the output circuit 22 to the control circuit 23 is smaller than the reference voltage Vr. For this reason, the voltage output to the second input terminal of the AND circuit 43 by the output portion 52 is input, as-is, from the output terminal of the AND circuit 43 to the charging circuit 45.

Next, the control portion 56 instructs the timer 54 to start to measure time (step S2), and determines whether or not the measured time that is measured by the timer 54 is longer than or equal to charging time (step S3). The charging time is constant and is stored in advance in the storage portion 55. If it is determined that the measured time is shorter than the charging time (S3: NO), the control portion 56 executes step S3 again and waits until the measured time becomes longer than or equal to the charging time.

If it is determined that the measured time is longer than or equal to the charging time (S3: YES), the control portion 56 instructs the output portion 52 to switch the voltage output to the control circuit 23 by the output portion 52 to the low-level voltage, and thus causes the charging circuit 45 to end the charging of the capacitor C2 (step S4). When the measured time becomes longer than or equal to the charging time or longer, the largest value of the voltage output by the output circuit 22 is smaller than the reference voltage Vr, and accordingly, the comparator 40 continues to output the low-level voltage. For this reason, in step S4, the voltage output to the second input terminal of the AND circuit 43 by the output portion 52 is input, as-is, to the charging circuit 45 in the control circuit 23.

Next, the control portion 56 instructs the output portion 53 to switch the voltage output to the control circuit 23 by the output portion 53 to the high-level voltage, and thus causes the discharging circuit 46 to start to discharge the capacitor C2 (step S5). Thus, the gate voltage of the semiconductor transistor 20 decreases, and the resistance between the drain and the source of the semiconductor transistor 20 increases.

Next, the control portion 56 resets the measured time that is measured by the timer 54 to zero (step S6), and determines whether or not the measured time that is measured by the timer 54 is longer than or equal to the discharging time (step S7). The discharging time is constant and is stored in advance in the storage portion 55.

If it is determined that the measured time is shorter than the discharging time (S7: NO), the control portion 56 executes step S7 again and waits until the measured time becomes longer than or equal to the discharging time or longer. If it is determined that the measured time is longer than or equal to the discharging time (S7: YES), the control portion 56 instructs the output portion 53 to switch the voltage output to the control circuit 23 by the output portion 53 to the low-level voltage, and thus causes the discharging circuit 46 to end the discharging of the capacitor C2 (step S8). After executing step S8, the control portion 56 instructs the timer 54 to end time measurement (step S9).

Next, the control portion 56 acquires, from the input portion 51, the voltage information input from the voltage detecting portion 21 to the input portion 51 (step S10), and determines whether or not the source voltage indicated by the acquired voltage information is larger than or equal to a standard voltage (step S11). The standard voltage is constant and is stored in advance in the storage portion 55. As will be described later, the source voltage being larger than or equal to the standard voltage in step S11 indicates that both ends of the capacitor C1 in the load 12 are not shorted, and the source voltage being smaller than the standard voltage indicates that both ends of the capacitor C1 in the load 12 are shorted.

If it is determined that the source voltage is smaller than the standard voltage (S11: NO), the control portion 56 regards both ends of the capacitor C1 in the load 12 as being shorted and ends the power supply start processing, and does not resume charging of the capacitor C1.

Note that, if it is determined that the source voltage is smaller than the standard voltage, the control portion 56 may also output a short circuit signal that indicates a short circuit of the capacitor C1 to an output portion (not shown), and thereafter end the power supply start processing.

If it is determined that the source voltage is larger than or equal to the standard voltage (S11: YES), the control portion 56 causes the charging circuit 45 to start to charge the capacitor C2, similarly to step S1 (step S12).

After executing step S11, the control portion 56 ends the power supply start processing in a state where the charging of the capacitor C1 is continued.

The control portion 56 performs the power supply end processing if the stop signal is input to the input portion 50. In the power supply end processing, the control portion 56 instructs the output portions 52 and 53 to switch the voltages output by the output portions 52 and 53 to the low-level voltage and the high-level voltage, respectively. Thus, the charging circuit 45 ends the charging of the capacitor C1, and the discharging circuit 46 starts to discharge the capacitor C1. After the control portion 56 has caused the discharging circuit 46 to discharge the capacitor C1 only for a fixed time and the gate voltage of the semiconductor transistor 20 has become 0 V, the control portion 56 instructs the output portion 53 to switch the voltage output to the control portion 56 by the output portion 53 to the low-level voltage. Thus, the discharging of the capacitor C1 performed by the discharging circuit 46 ends. The control portion 56 instructs the output portion 53 to switch the voltage output to the control portion 56 by the output portion 53 to the low-level voltage, and thereafter ends the power supply end processing.

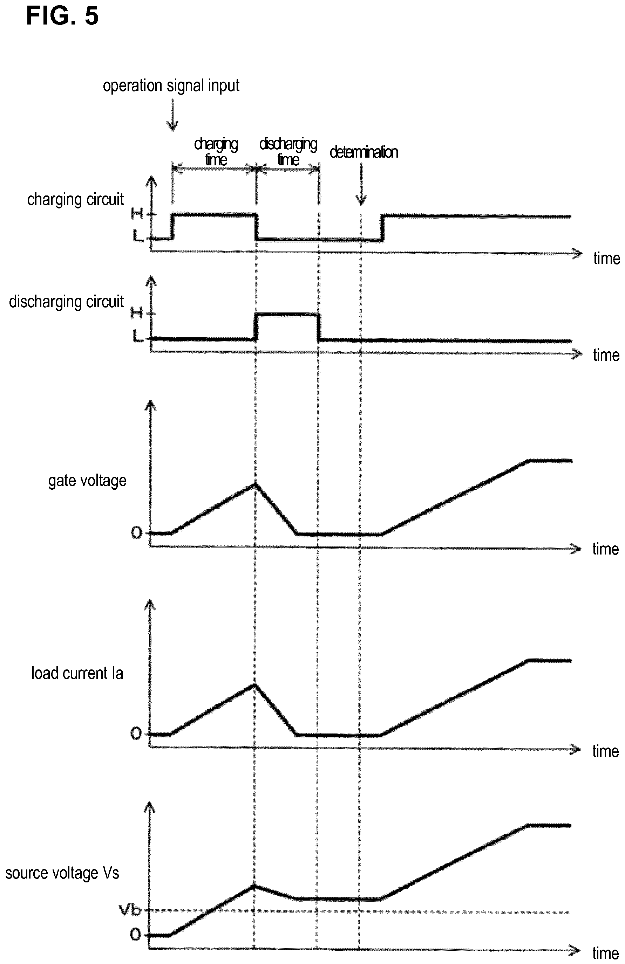

FIG. 5 is a timing chart showing an example of operations in the power supply control apparatus 11. FIG. 5 shows graphs of the voltages input to the charging circuit 45 and the discharging circuit 46, and graphs of the gate voltage, load current Ia, and the source voltage Vs. These graphs occur in the case where both ends of the load 12 are not shorted. The horizontal axis indicates time. In FIG. 5, a high-level voltage is denoted as "H", and a low-level voltage is denoted as "L".

As mentioned above, the control portion 56 in the microcomputer 24 executes the power supply start processing if the operation signal is input to the input portion 50 in the microcomputer 24. In the power supply start processing, initially, the microcomputer 24 switches the voltage input to the charging circuit 45 to the high-level voltage while keeping the voltage input to the discharging circuit 46 to the low-level voltage, and causes the charging circuit 45 in the control circuit 23 to start to charge the capacitor C2. As a result, the voltage across both ends of the capacitor C2, i.e. the gate voltage gradually increases, and the resistance between the drain and the source of the semiconductor transistor 20 gradually decreases.

If the resistance between the drain and the source of the semiconductor transistor 20 decreases, the load current Ia flows from the battery 10 to the load 12 via the semiconductor transistor 20. As the resistance between the drain and the source of the semiconductor transistor 20 gradually decreases, the load current Ia also gradually increases.

Since the resistance between the drain and the source of the semiconductor transistor 20 gradually decreases as described above, an inrush current can be reliably prevented from flowing through the load 12 via the semiconductor transistor 20.

Unless both ends of the load 12 are shorted, the source voltage Vs of the semiconductor transistor 20 gradually increases as the resistance between the drain and the source of the semiconductor transistor 20 gradually decreases. Also, as a result of power being supplied from the battery 10 to the load 12, the capacitor C1 in the load 12 is charged, and the voltage across both ends of the capacitor C1 also increases.

If the charging time has elapsed since the charging circuit 45 started to charge the capacitor C2, the microcomputer 24 switches the voltage input to the charging circuit 45 to the low-level voltage, and causes the charging circuit 45 to end the charging of the capacitor C2. As a result, the increase in the gate voltage, the load current Ia, the source voltage, and the voltage across both ends of the capacitor C1 stop.

Next, the microcomputer 24 switches the voltage input to the discharging circuit 46 from the low-level voltage to the high-level voltage, and causes the discharging circuit 46 to start to discharge the capacitor C2. As a result, the voltage across both ends of the capacitor C2 decreases, and the gate voltage of the semiconductor transistor 20 decreases. As a result of the decrease in the gate voltage, the resistance between the drain and the source of the semiconductor transistor 20 increases, and the load current Ia decreases. With the decrease in the load current Ia, the source voltage Vs also decreases to the voltage across both ends of the capacitor C1.

The discharging time is sufficiently longer than the time required for the voltage across both ends of the capacitor C2 to become 0 V due to the discharging performed by the discharging circuit 46. For this reason, when the discharging time has elapsed since the voltage input to the discharging circuit 46 was switched from the low-level voltage to the high-level voltage, the gate voltage is 0 V, and the drain and the source of the semiconductor transistor 20 are in an open state. When the discharging time has elapsed, no current is flowing through the resistor Ra, and accordingly, the source voltage Vs coincides with the voltage across both ends of the capacitor C1.

Unless both ends of the load 12 are shorted, the voltage across both ends of the capacitor C1 becomes larger than or equal to a standard voltage Vb until the charging time has elapsed since the operation signal was input to the input portion 50. Accordingly, unless both ends of the load 12 are shorted, the source voltage Vs is larger than or equal to the standard voltage Vb when the discharging time has elapsed.

After the discharging circuit 46 ends the discharging of the capacitor C2 in the control circuit 23, the control portion 56 in the microcomputer 24 determines whether or not the source voltage Vs indicated by the voltage information input from the voltage detecting portion 21 is larger than or equal to the standard voltage Vb.

If it is determined by the control portion 56 that the source voltage Vs is larger than or equal to the standard voltage Vb, the microcomputer 24 regards both ends of the load 12 as not being shorted, and switches the voltage input to the charging circuit 45 from the low-level voltage to the high-level voltage, and the control portion 56 in the microcomputer 24 ends the power supply start processing. The control portion 56 functions as a determining portion, and the standard voltage Vb corresponds to a predetermined voltage.

As a result of thus switching the voltage, the charging circuit 45 again charges the capacitor C2 in the control circuit 23, increases the gate voltage of the semiconductor transistor 20, and decreases the resistance between the drain and the source of the semiconductor transistor 20. As a result, power is supplied from the battery 10 to the load 12, and the load current Ia and the source voltage Vs increase again.

At this time, since both ends of the load 12 are not shorted, the load current Ia does not become larger than or equal to the current threshold Ith ($=Vr \times re/(ra \times rd)$) while the largest value of the voltage output from the output circuit 22 to the control circuit 23 is smaller than the reference voltage Vr.

In the control circuit 23, if the voltage output to the capacitor C2 by the charging circuit 45 coincides with the voltage across both ends of the capacitor C2, the gate voltage stops increasing and is stabilized. As a result, the load current Ia and the source voltage Vs also stop increasing and are stabilized.

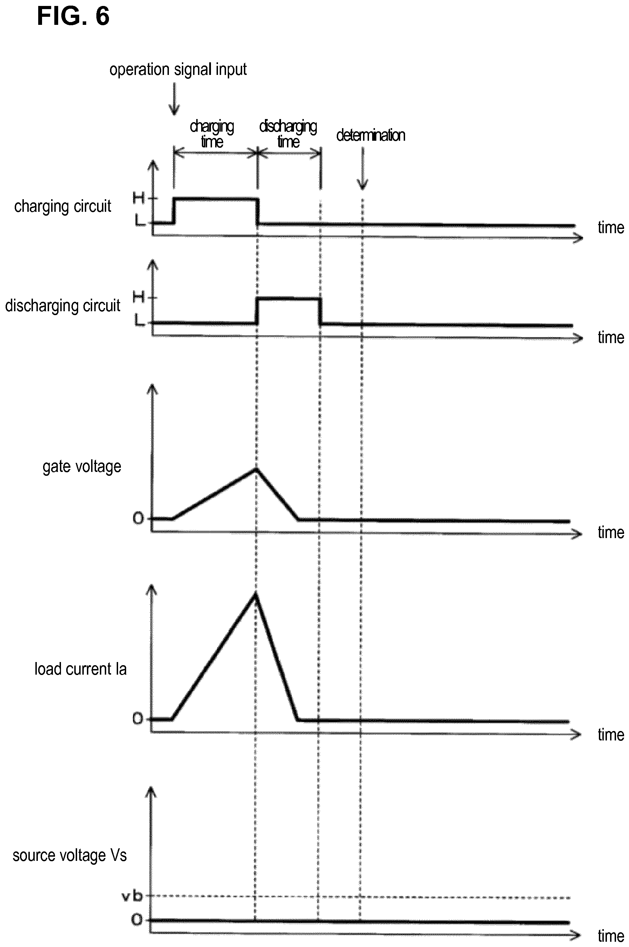

FIG. 6 is a timing chart showing another example of operations of the power supply control apparatus 11. Similar to FIG. 5, FIG. 6 shows graphs of the voltages input to the charging circuit 45 and the discharging circuit 46, and graphs of the gate voltage, the load current Ia, and the source voltage Vs. These graphs are for the case where both ends of the load 12 are shorted. The horizontal axis indicates time. In FIG. 6 as well, a high-level voltage is denoted as "H", and a low-level voltage is denoted as "L".

As mentioned above, the control portion 56 in the microcomputer 24 executes the power supply start processing if the operation signal is input to the input portion 50 in the microcomputer 24. The microcomputer 24 switches the voltage input to the charging circuit 45 in the control circuit 23 to the high-level voltage while keeping the voltage input to the discharging circuit 46 to the low-level voltage, and causes the charging circuit 45 to start to charge the capacitor C2. As a result, the voltage across both ends of the capacitor C2 gradually increases, and the resistance between the drain and the source of the semiconductor transistor 20 gradually decreases.

If the resistance between the drain and the source of the semiconductor transistor 20 decreases, a current flows from the battery 10 to the load 12 via the semiconductor transistor 20. Here, since both ends of the load 12 are shorted, the load current Ia that flows through the resistor Ra sharply increases as the resistance between the drain and the source of the semiconductor transistor 20 decreases. Also, since both ends of the load 12 are shorted, the source voltage Vs is substantially 0 V.

If the charging time has elapsed since the charging circuit 45 started to charge the capacitor C2, the microcomputer 24 switches the voltage input to the charging circuit 45 to the low-level voltage, and causes the charging circuit 45 to end the charging of the capacitor C2. Thus, the gate voltage and the load current Ia stop increasing.

Next, the microcomputer 24 switches the voltage input to the discharging circuit 46 from the low-level voltage to the high-level voltage, and causes the discharging circuit 46 to start to discharge the capacitor C2. As a result, the voltage across both ends of the capacitor C2 decreases, and the gate voltage of the semiconductor transistor 20 decreases. As a result of the decrease in the gate voltage, the resistance between the drain and the source of the semiconductor transistor 20 increases, and the load current Ia decreases. If the discharging time has elapsed since the voltage input to the discharging circuit 46 switched from the low-level voltage to the high-level voltage, the microcomputer 24 restores the voltage input to the discharging circuit 46 to the low-level voltage, and the discharging circuit 46 ends the discharging of the capacitor C2. When the discharging of the capacitor C2 ends, the gate voltage is 0 V, and the drain and the source of the semiconductor transistor 20 are in an open state.

While the charging circuit 45 and the discharging circuit 46 are performing the charging and discharging, the source voltage Vs is substantially 0 V, and is smaller than the standard voltage Vb.

After the discharging circuit 46 ends the discharging of the capacitor C2 in the control circuit 23, the control portion 56 in the microcomputer 24 determines whether or not the source voltage Vs indicated by the voltage information input from the voltage detecting portion 21 is larger than or equal to the standard voltage Vb. If it is determined by the control portion 56 that the source voltage Vs is smaller than the standard voltage Vb, the power supply start processing ends while the voltages input to the charging circuit 45 and the discharging circuit 46 are kept to the low-level voltage.

Thus, if it is determined that the source voltage Vs is smaller than the standard voltage Vb, the control portion 56 keeps the resistance between the drain and the source of the semiconductor transistor 20 to the resistance at the time when the determination was performed, and reliably prevents an overcurrent from flowing through the semiconductor transistor 20.

In addition, after the charging circuit 45 has charged the capacitor C1, the discharging circuit 46 discharges the capacitor C1 to temporarily stop power supply from the battery 10 to the load 12. Accordingly, power is not needlessly consumed when both ends of the load 12 are shorted.

In the power supply control apparatus 11, if the source voltage Vs is larger than or equal to Vr×(rd+re)/rd, the largest value of the voltage output from the output circuit 22 to the control circuit 23 is larger than or equal to the reference voltage Vr. For this reason, an overcurrent is prevented from flowing through the semiconductor transistor 20 by adjusting the resistance between the drain and the source of the semiconductor transistor 20 based on the voltage output from the output circuit 22 to the control circuit 23. If the source voltage Vs is smaller than Vr×(rd+re)/rd, the largest value of the voltage output from the output circuit 22 to the control circuit 23 is smaller than the reference voltage Vr. For this reason, a flow of an overcurrent is prevented by adjusting the resistance between the drain and the source of the semiconductor transistor 20 based on the source voltage Vs indicated by the voltage information input from the voltage detecting portion 21.

Embodiment 2

In Embodiment 2, the power supply system 1 is configured similarly to Embodiment 1, whereas the content of the power supply start processing executed by the control portion 56 in the microcomputer 24 differs from Embodiment 1.

In the following description, the content of the power supply start processing executed by the control portion 56 according to Embodiment 2 will be described. The structures that are common to Embodiment 1 are assigned the same reference signs as those in Embodiment 1, and a description thereof will be omitted accordingly.

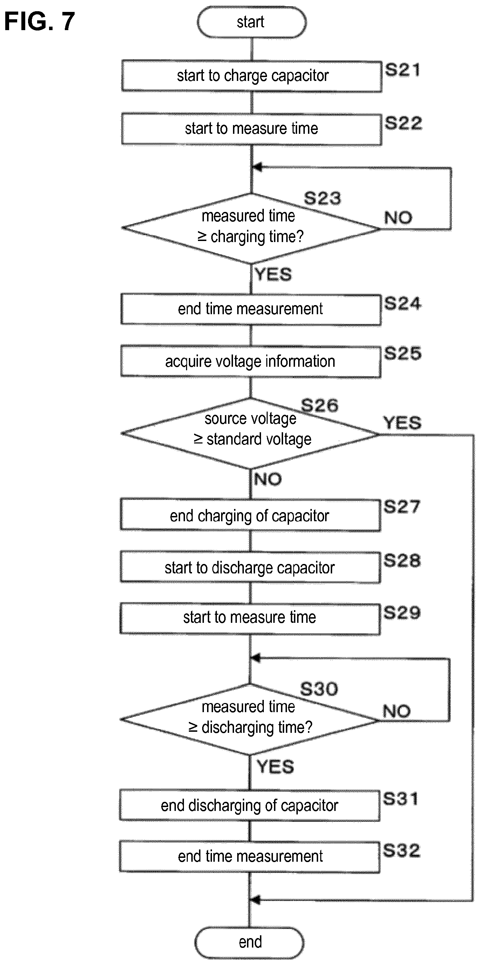

FIG. 7 is a flowchart showing a procedure of the power supply start processing executed by a control portion 56 according to Embodiment 2. The control portion 56 executes the power supply start processing if the operation signal is input to the input portion 50. The power supply start processing starts in a state where the output portions 52 and 53 output the low-level voltage to the second terminals of the AND circuit 43 and the OR circuit 44, respectively, in the control circuit 23, i.e. in a state where the charging circuit 45 and the discharging circuit 46 stop operation.

Initially, similarly to step S1 in the power supply start processing according to Embodiment 1, the control portion 56 causes the charging circuit 45 to start to charge the capacitor C2 in the control circuit 23 (step S21), and instructs the timer 54 to start to measure time (step S22). Next, the control portion 56 determines whether or not the measured time that is measured by the timer 54 is longer than or equal to the charging time (step S23). If it is determined that the measured time is shorter than the charging time (S23: NO), the control portion 56 again executes step S23 and waits until the measured time becomes longer than or equal to the charging time.

If it is determined that the measured time is longer than or equal to the charging time (S23: YES), the control portion 56 instructs the timer 54 to end time measurement (step S24), and acquires, from the input portion 51, the voltage information input from the voltage detecting portion 21 to the input portion 51 (step S25). At this point, the charging of the capacitor C2 in the control circuit 23 is continued.

Next, the control portion 56 determines whether or not the source voltage indicated by the voltage information acquired in step S25 is larger than or equal to the standard voltage (step S26). Unless both ends of the capacitor C2 in the load 12 are shorted, the voltage across both ends of the capacitor C1 is larger than or equal to the standard voltage, similarly to Embodiment 2. If both ends of the capacitor C2 in the load 12 are shorted, hardly any power is stored in the capacitor C1, and the voltage across both ends of the capacitor C1 is substantially 0 V and is smaller than the standard voltage.

If it is determined that the source voltage is smaller than the standard voltage (S26: NO), the control portion 56 causes the charging circuit 45 to end the charging of the capacitor C2 (step S27), similarly to step S4 in the power supply start processing according to Embodiment 1. After executing step S27, the control portion 56 causes the discharging circuit 46 to start to discharge the capacitor C2 (step S28), similarly to step S5 in the power supply start processing according to Embodiment 1.

Next, the control portion 56 instructs the timer 54 to measure time (step S29), and determines whether or not the measured time that is measured by the timer 54 is longer than or equal to the discharging time (step S30). If it is determined that the measured time is shorter than the discharging time (S30: NO), the control portion 56 again executes step S30 and waits until the measured time becomes longer than or equal to the discharging time.

If it is determined that the measured time is longer than or equal to the discharging time (S30: YES), the control portion 56 causes the discharging circuit 46 to end the discharging of the capacitor C2 (step S31) similarly to step S8 in the power supply start processing according to Embodiment 1, and instructs the timer 54 to end time measurement (step S32). If it is determined that the source voltage is larger than or equal to the standard voltage (S26: YES), or after the control portion 56 has executed step S32, the control portion 56 ends the power supply start processing.

If the control portion 56 executes step S32 and ends the power supply start processing, the control portion 56 does not resume the charging of the capacitor C1 since both ends of the capacitor C1 in the load 12 are shorted.

If the control portion 56 determines that the source voltage is larger than or equal to the standard voltage and ends the power supply start processing, the control portion 56 ends the power supply start processing in a state where the charging circuit 45 continues to charge the capacitor C1, since both ends of the capacitor C1 in the load 12 are not shorted.

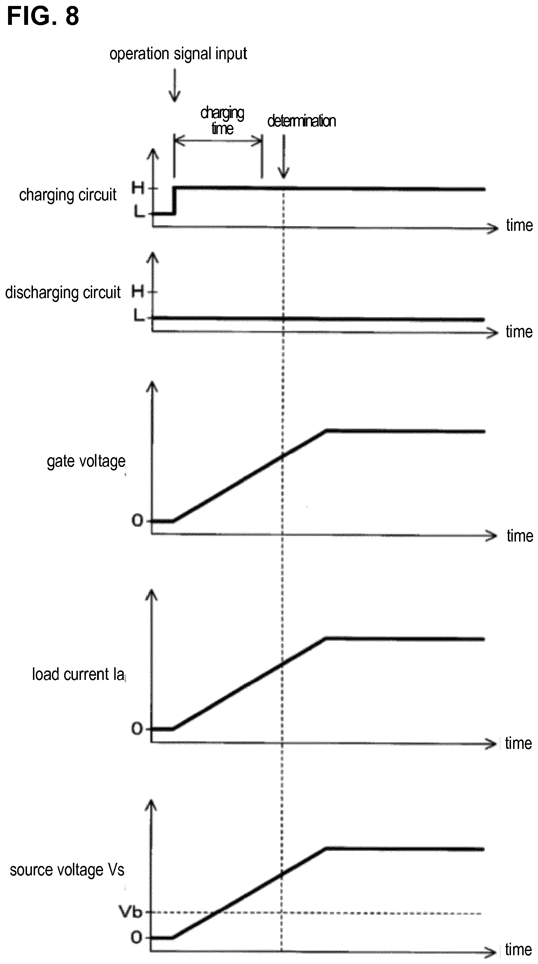

FIG. 8 is a timing chart showing an example of operations of the power supply control apparatus 11. Similar to FIG. 5, FIG. 8 shows graphs of the voltages input to the charging circuit 45 and the discharging circuit 46, and graphs of the gate voltage, the load current Ia, and the source voltage Vs. These graphs occur in the case where both ends of the load 12 are not shorted. The horizontal axis indicates time. In FIG. 8 as well, a high-level voltage is denoted as "H", and a low-level voltage is denoted as "L".

As mentioned above, the control portion 56 in the microcomputer 24 executes the power supply start processing if the operation signal is input to the input portion 50 in the microcomputer 24. In the power supply start processing, initially, the microcomputer 24 switches the voltage input to the charging circuit 45 to the high-level voltage while keeping the voltage input to the discharging circuit 46 to the low-level voltage, and the charging circuit 45 in the control circuit 23 starts to charge the capacitor C2, similarly to Embodiment 1.

Thus, the gate voltage of the semiconductor transistor 20 gradually increases, and the resistance between the drain and the source of the semiconductor transistor 20 gradually decreases. With this decrease in the resistance, the load current Ia also gradually increases. Unless both ends of the load 12 are shorted, the source voltage Vs of the semiconductor transistor 20 also gradually increases. Also, as a result of the load current Ia flowing from the battery 10 to the load 12, the capacitor C1 in the load 12 is charged, and the voltage across both ends of the capacitor C1 also increases.

Since the resistance between the drain and the source of the semiconductor transistor 20 gradually decreases similarly to Embodiment 1, an inrush current can be reliably prevented from flowing through the load 12 via the semiconductor transistor 20.

After the charging time has elapsed since the charging circuit 45 started to charge the capacitor C2, the control portion 56 in the microcomputer 24 determines whether or not the source voltage Vs indicated by the voltage information input from the voltage detecting portion 21 is larger than or equal to the standard voltage Vb. At this time, the high-level voltage is input to the charging circuit 45, and the charging circuit 45 continues to charge the capacitor C2.

Also, unless both ends of the load 12 are shorted, the voltage across both ends of the capacitor C1 becomes larger than or equal to the standard voltage Vb until the charging time has elapsed since the operation signal was input to the input portion 50.

If it is determined by the control portion 56 that the source voltage Vs is larger than or equal to the standard voltage Vb, the microcomputer 24 regards both ends of the load 12 as not being shorted, keeps the voltage input to the charging circuit 45 to the high-level voltage, and continues to lower the resistance between the drain and the source of the semiconductor transistor 20. The control portion 56 ends the power supply start processing while keeping the voltage input to the charging circuit 45 to the high-level voltage.

If the voltage output to the capacitor C2 in the control circuit 23 by the charging circuit 45 coincides with the voltage across both ends of the capacitor C2, the gate voltage stops increasing and is stabilized. As a result, the load current Ia and the source voltage Vs also stop increasing and are stabilized.

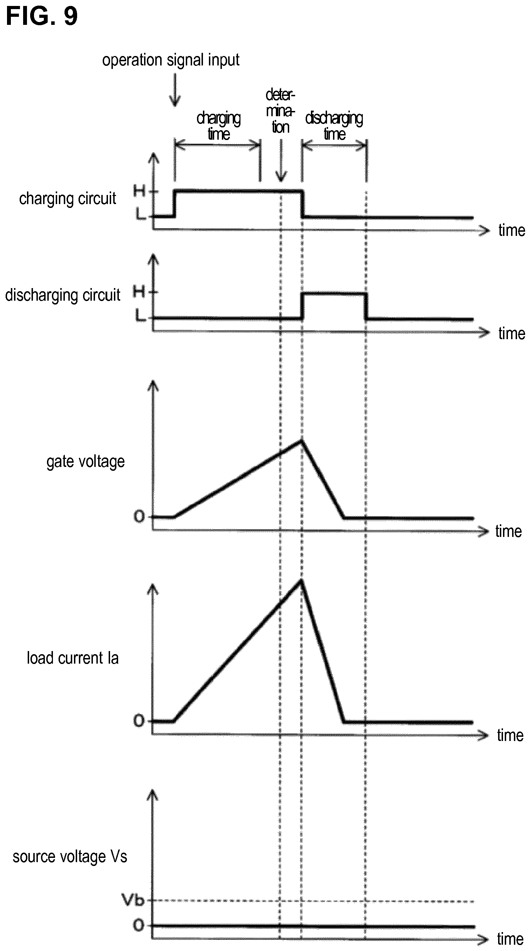

FIG. 9 is a timing chart showing another example of operations of the power supply control apparatus 11. Similar to FIG. 8, FIG. 9 shows graphs of the voltages input to the charging circuit 45 and the discharging circuit 46, and graphs of the gate voltage, the load current Ia, and the source voltage Vs. These graphs are for the case where both ends of the load 12 are shorted. The horizontal axis indicates time. In FIG. 9 as well, a high-level voltage is denoted as "H", and a low-level voltage is denoted as "L".

As mentioned above, the control portion 56 in the microcomputer 24 executes the power supply start processing if the operation signal is input to the input portion 50 in the microcomputer 24. Initially, the microcomputer 24 switches the voltage input to the charging circuit 45 in the control circuit 23 to the high-level voltage while keeping the voltage input to the discharging circuit 46 to the low-level voltage, and the charging circuit 45 starts to charge the capacitor C2, similarly to Embodiment 1.

Thus, the gate voltage of the semiconductor transistor 20 gradually increases, and the resistance between the drain and the source of the semiconductor transistor 20 gradually decreases. As a result of this decrease in the resistance, a current flows from the battery 10 to the load 12 via the semiconductor transistor 20. Here, since both ends of the load 12 are shorted, the load current Ia that flows through the resistor Ra sharply increases as the resistance between the drain and the source of the semiconductor transistor 20 decreases. Also, since both ends of the load 12 are shorted, the source voltage Vs is substantially 0 V.

After the charging time has elapsed since the charging circuit 45 started to charge the capacitor C2, the control portion 56 in the microcomputer 24 determines whether or not the source voltage Vs indicated by the voltage information input from the voltage detecting portion 21 is larger than or equal to the standard voltage Vb. At this time, the high-level voltage is input to the charging circuit 45, and the charging circuit 45 continues to charge the capacitor C2.

If it is determined by the control portion 56 that the source voltage Vs is smaller than the standard voltage Vb, the microcomputer 24 regards both ends of the load 12 as being shorted, and switches the voltages input to the charging circuit 45 and the discharging circuit 46 to the low-level voltage and the high-level voltage, respectively. Thus, the charging circuit 45 ends the charging of the capacitor C2, and the discharging circuit 46 starts to discharge the capacitor C2. As a result, the voltage across both ends of the capacitor C2 decreases, and the gate voltage of the semiconductor transistor 20 decreases. As a result of the decrease in the gate voltage, the resistance between the drain and the source of the semiconductor transistor 20 increases, and the load current Ia decreases. The source voltage Vs remains substantially 0 V.

If the discharging time has elapsed since the voltage input to the discharging circuit 46 was switched from the low-level voltage to the high-level voltage, the microcomputer 24 restores the voltage input to the discharging circuit 46 from the high-level voltage to the low-level voltage, and the discharging circuit 46 ends the discharging of the capacitor C2.

Thus, if it is determined that the source voltage Vs is smaller than the standard voltage Vb, the control portion 56 increases the resistance between the drain and the source of the semiconductor transistor 20 to a resistance higher than the resistance at the time when the determination was performed, and reliably prevents an overcurrent from flowing through the semiconductor transistor 20.

In the power supply control apparatus 11 according to Embodiment 2, if the source voltage Vs is larger than or equal to Vr×(rd+re)/rd, an overcurrent is prevented from flowing through the semiconductor transistor 20 by adjusting the resistance between the drain and the source of the semiconductor transistor 20 based on the voltage output from the output circuit 22 to the control circuit 23, similarly to Embodiment 1. If the source voltage Vs is smaller than Vr×(rd+re)/rd, a flow of an overcurrent is prevented by adjusting the resistance between the drain and the source of the semiconductor transistor 20 based on the source voltage Vs indicated by the voltage information input from the voltage detecting portion 21.

Note that, in Embodiments 1 and 2, the capacitor C2 in the control circuit 23 need only be a capacitor whose one end is connected to the gate of the semiconductor transistor 20. Accordingly, the other end of the capacitor C2 may also be connected to the drain or the source of the semiconductor transistor 20. In this case, the capacitor C2 may also be an input capacitance that is formed when the semiconductor transistor 20 is manufactured.

The semiconductor transistor 20 is not limited to an N-channel FET, and may also be an NPN bipolar transistor, for example. Furthermore, the semiconductor transistor 20 may also be a P-channel FET, a PNP bipolar transistor, or the like. For example, if the semiconductor transistor 20 is a P-channel FET, the drain is connected to one end of the capacitor C1 in the load 12, and the source is connected to the positive electrode of the battery 10. The control circuit 23 gradually increases the resistance between the source and the drain of the semiconductor transistor 20 by gradually lowering the voltage at the gate, and gradually lowers the resistance between the source and the drain of the semiconductor transistor 20 by gradually increasing the voltage at the gate.

Furthermore, the output circuit 22 is not limited to a circuit that is constituted by the PNP bipolar transistor 30, the differential amplifier 31, and the resistors Rd and Re. The output circuit 22 need only be a circuit that outputs a voltage that is proportional to the load current Ia and whose largest value is smaller than or equal to the source voltage Vs.

Embodiments 1 and 2 disclosed above are examples in all aspects, and should be considered to be non-restrictive. The scope of the present invention is indicated not by the above-stated meanings but by the claims, and is intended to include all modifications within the meanings and scope equivalent to the claims.

List of Reference Numerals

| 12 | Load |
| 20 | Semiconductor transistor |
| 23 | Control circuit (adjusting portion) |
| 11 | Power supply control apparatus |
| 21 | Voltage detecting portion |
| 56 | Control portion (determining portion) |
| 22 | Output circuit |

**Claims**

1. A power supply control apparatus that includes a semiconductor transistor for outputting a current that is input to its input terminal, from its output terminal to a capacitive load, and an adjusting portion for adjusting a resistance between the input terminal and the output terminal of the semiconductor transistor, and controls power supply to the load by adjusting the resistance with the adjusting portion, the power supply control apparatus comprising:

   a detecting portion for detecting a voltage at the output terminal; and
   a determining portion for determining whether or not the voltage at the output terminal detected by the detecting portion is larger than or equal to a predetermined voltage, after the adjusting portion has lowered the resistance,
   wherein the adjusting portion
   again lowers the resistance if it is determined by the determining portion that the voltage at the output terminal is larger than or equal to the predetermined voltage, and
   if it is determined by the determining portion that the voltage at the output terminal is smaller than the predetermined voltage, adjusts the resistance to at least the resistance at the time when the determining portion performed the determination.

2. The power supply control apparatus according to claim 1,
   wherein the adjusting portion lowers the resistance and thereafter increases the resistance before the determining portion performs the determination, and the determining portion performs the determination after the adjusting portion has increased the resistance.

3. The power supply control apparatus according to claim 1 or 2, further comprising:

   an output circuit that outputs a higher voltage the larger a current flowing through the load is,
   wherein the adjusting portion increases the resistance if the voltage output by the output circuit is larger than or equal to a threshold, and
   the largest value of the voltage output by the output circuit is smaller than or equal to the voltage at the output terminal, and increases with an increase in the voltage at the output terminal.

# FIG. 1

# FIG. 2

# FIG. 3

**FIG. 4**

start

S1 start to charge capacitor

S2 start to measure time

S3 measured time ≥ charging time? — NO

YES

S4 end charging of capacitor

S5 start to discharge capacitor

S6 reset measured time to zero

S7 measured time ≥ discharging time? — NO

YES

S8 end discharging of capacitor

S9 end time measurement

S10 acquire voltage information

S11 source voltage ≥ standard voltage — NO

YES

S12 start to charge capacitor

end

# FIG. 5

operation signal input

charging time | discharging time | determination

charging circuit

H
L

time

discharging circuit

H
L

time

gate voltage

O

time

load current Ia

O

time

source voltage Vs

Vb
O

time

# FIG. 6

operation signal input

charging time | discharging time | determination

charging circuit — time

discharging circuit — time

gate voltage — time

load current Ia — time

source voltage Vs — time

**FIG. 7**

```
                    ( start )
                       │
         ┌─────────────────────────────┐
         │   start to charge capacitor  │ S21
         └─────────────────────────────┘
                       │
         ┌─────────────────────────────┐
         │     start to measure time    │ S22
         └─────────────────────────────┘
                       │
                       ▼ ◄──────────────────┐
                    ╱        ╲  S23           │
                  ╱  measured  ╲     NO       │
                 ╱   time       ╲────────────┘
                  ╲ ≥ charging  ╱
                    ╲ time?   ╱
                       │ YES
         ┌─────────────────────────────┐
         │     end time measurement     │ S24
         └─────────────────────────────┘
                       │
         ┌─────────────────────────────┐
         │   acquire voltage information │ S25
         └─────────────────────────────┘
                       │
                    ╱        ╲  S26
                  ╱  source    ╲    YES ──────┐
                 ╱   voltage    ╲             │
                  ╲ ≥ standard  ╱             │
                    ╲ voltage ╱               │
                       │ NO                   │
         ┌─────────────────────────────┐      │
         │   end charging of capacitor  │ S27  │
         └─────────────────────────────┘      │
                       │                       │
         ┌─────────────────────────────┐      │
         │  start to discharge capacitor │ S28  │
         └─────────────────────────────┘      │
                       │                       │
         ┌─────────────────────────────┐      │
         │     start to measure time    │ S29  │
         └─────────────────────────────┘      │
                       │                       │
                       ▼ ◄──────────────┐      │
                    ╱        ╲  S30       │      │
                  ╱  measured  ╲    NO     │      │
                 ╱   time       ╲─────────┘      │
                  ╲ ≥ discharging ╱             │
                    ╲ time?   ╱                 │
                       │ YES                    │
         ┌─────────────────────────────┐        │
         │ end discharging of capacitor │ S31    │
         └─────────────────────────────┘        │
                       │                         │
         ┌─────────────────────────────┐        │
         │     end time measurement     │ S32    │
         └─────────────────────────────┘        │
                       │ ◄──────────────────────┘
                    ( end )
```

# FIG. 8

operation signal input

charging time

determination

charging circuit

H

L

time

discharging circuit

H

L

time

gate voltage

O

time

load current Ia

O

time

source voltage Vs

Vb

O

time

# FIG. 9

operation signal input

charging time

deter-mina-tion

discharging time

charging circuit
H
L
time

discharging circuit
H
L
time

gate voltage
O
time

load current Ia
O
time

source voltage Vs
Vb
O
time

## INTERNATIONAL SEARCH REPORT

| International application No. |
| --- |
| PCT/JP2016/088112 |

**A. CLASSIFICATION OF SUBJECT MATTER**
*H02J1/00*(2006.01)i, *H02H9/02*(2006.01)i, *H03K17/16*(2006.01)i

According to International Patent Classification (IPC) or to both national classification and IPC

**B. FIELDS SEARCHED**

Minimum documentation searched (classification system followed by classification symbols)
H02J1/00, H02H9/02, H03K17/16

Documentation searched other than minimum documentation to the extent that such documents are included in the fields searched
Jitsuyo Shinan Koho        1922–1996   Jitsuyo Shinan Toroku Koho    1996–2017
Kokai Jitsuyo Shinan Koho  1971–2017   Toroku Jitsuyo Shinan Koho    1994–2017

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2007-215300 A  (Toshiba Tec Corp.), 23 August 2007 (23.08.2007), entire text; all drawings (Family: none) | 1-3 |
| A | JP 2005-323489 A  (Yazaki Corp.), 17 November 2005 (17.11.2005), entire text; all drawings (Family: none) | 1-3 |

☐ Further documents are listed in the continuation of Box C.   ☐ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered    to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 01 February 2017 (01.02.17) | 14 February 2017 (14.02.17) |

| Name and mailing address of the ISA/ | Authorized officer |
| --- | --- |
| Japan Patent Office 3-4-3,Kasumigaseki,Chiyoda-ku, Tokyo 100-8915,Japan | Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004135389 A